# EUROPEAN PATENT APPLICATION

(11) **EP 2 934 069 A1**
(43) Date of publication of application: **21.10.2015**
(21) Application number: 13862138.8
(22) Date of filing: 27.11.2013
(51) Int. Cl.: H05B 37/02

(54) **WALL SWITCH**

(30) Priority: 13.12.2012 JP 2012271897
(71) Applicant: Panasonic Intellectual Property Management Co., Ltd., Osaka-shi, Osaka 540-6207 (JP)
(72) Inventor: KATO, Kazuhiro, Osaka-shi Osaka 540-6207 (JP); KAWAI, ATSUSHI, Osaka-shi Osaka 540-6207 (JP)
(74) Representative: Appelt, Christian W.
(86) International application number: PCT/JP2013/006983
(87) International publication number: WO 2014/091698

(57) **Abstract**

A touch sensor is configured to detect a touch operation of touching a prescribed operation area of a wall switch with a finger. A signal processing portion is configured to change a light control signal to be output from an output circuit, based on a detection result of the touch sensor, to control lighting of an illumination load. In a non-lighting state, the signal processing portion is configured to set a dimming level of the illumination load to a first dimming level, if the touch sensor detects no next touch operation during a lapse of a prescribed time period after detecting the touch operation. In the non-lighting state, the signal processing portion is configured to set the dimming level of the illumination load to a second dimming level that is different from the first dimming level, if the touch sensor detects a next touch operation during the lapse of the prescribed time period after detecting the touch operation.

## Description

### TECHNICAL FIELD

The invention relates to a wall switch.

### BACKGROUND ART

Conventionally, there has been a fluorescent lamp lighting device, which includes a touch switch and is configured to periodically switch brightness of a fluorescent lamp in order of full-lighting, dimming-lighting and non-lighting, whenever a user touches the touch switch with the user's finger (e.g., see JPH 01-286298 A).

The above-mentioned conventional fluorescent lamp lighting device periodically switches the brightness of the fluorescent lamp in order of the full-lighting, dimming lighting and non-lighting by the user touching the touch switch with the user's finger. In this case, in order to switch the brightness from a non-lighting state to a full-lighting state, it is required that the user touches the touch switch only once with the user's finger. On the other hand, in order to switch the brightness from the non-lighting state to a dimming-lighting state, it is required that after touching the touch switch once with the user's finger to switch the brightness from the non-lighting state to the full-lighting state, the user further touches the touch switch once with the user's finger to switch the brightness from the full-lighting state to the dimming-lighting state. In this way, it is required that operation for switching the brightness is performed twice to switch the brightness of the fluorescent lamp from the non-lighting state to the dimming-lighting state, and therefore, it makes operation troublesome. In the case where the brightness is switched from the non-lighting state to the dimming-lighting state, after turning on an illumination load in the full-lighting state once, a lighting controller switches the brightness from the full-lighting state to the dimming-lighting state. Therefore, there is a problem that it takes a long time for the illumination load to be turned on in the dimming-lighting state.

### DISCLOSURE OF THE INVENTION

It is an object of the present invention to provide a wall switch, which can facilitate operation for switching brightness of an illumination load to a desired dimming level.

A wall switch according to the present invention includes a touch sensor configured to detect a touch operation of touching a prescribed operation area with a finger, and a lighting controller configured to control lighting of an illumination load based on a detection result of the touch sensor. When the illumination load is in a non-lighting state, the lighting controller is configured to turn on the illumination load at a first dimming level, if the touch sensor detects no next touch operation during a lapse of a prescribed time period after detecting the touch operation. When the illumination load is in the non-lighting state, the lighting controller is configured to turn on the illumination load at a second dimming level that is different from the first dimming level, if the touch sensor detects a next touch operation during the lapse of the prescribed time period after detecting the touch operation. Note that, the above-mentioned prescribed time period is a time period of a degree capable of determining that the touch operation has been continuously performed two or more times, and is a time period of about 0.5 sec to 1.0 sec, for example.

In the present invention, preferably, when the illumination load is in a lighting state at the first dimming level, the lighting controller is configured to turn off the illumination load, if the touch sensor detects no next touch operation during the lapse of the prescribed time period after detecting the touch operation. Further, preferably, when the illumination load is in the lighting state at the first dimming level, the lighting controller is configured to turn on the illumination load at the second dimming level, if the touch sensor detects the next touch operation during the lapse of the prescribed time period after detecting the touch operation.

In the present invention, preferably, when the illumination load is in a lighting state at the second dimming level, the lighting controller is configured to turn off the illumination load, if the touch sensor detects no next touch operation during the lapse of the prescribed time period after detecting the touch operation. Further, preferably, when the illumination load is in the lighting state at the second dimming level, the lighting controller is configured to turn on the illumination load at the first dimming level, if the touch sensor detects the next touch operation during the lapse of the prescribed time period after detecting the touch operation.

In the present invention, preferably, the second dimming level is a dimming level of 100%.

Note that, as a matter of course, when the illumination load is in the lighting state at the first or second dimming level, a change destination of the brightness, corresponding to the number of times of the touch operation within the prescribed time period, is not limited to the above-mentioned contents. The change destination may be as follows.

That is, when the illumination load is in the lighting state at the first dimming level, the lighting controller may be configured to turn on the illumination load at the second dimming level, if the touch sensor detects no next touch operation during the lapse of the prescribed time period after detecting the touch operation. Further, when the illumination load is in the lighting state at the first dimming level, the lighting controller may be configured to turn off the illumination load, if the touch sensor detects the next touch operation during the lapse of the prescribed time period after detecting the touch operation.

When the illumination load is in the lighting state at the second dimming level, the lighting controller may be configured to turn on the illumination load at the first dimming level, if the touch sensor detects no next touch operation during the lapse of the prescribed time period after detecting the touch operation. Further, when the illumination load is in the lighting state at the second dimming level, the lighting controller may be configured to turn off the illumination load, if the touch sensor detects the next touch operation during the lapse of the prescribed time period after detecting the touch operation.

According to the present invention, in the non-lighting state, when the touch operation is performed only once within the prescribed time period, the lighting controller is configured to turn on the illumination load at the first dimming level based on the detection result of the touch sensor. In the non-lighting state, when the touch operation is performed two or more times within the prescribed time period, the lighting controller is configured to turn on the illumination load at the second dimming level based on the detection result of the touch sensor. In this way, the brightness of the illumination load can be directly switched to the first dimming level or the second dimming level, depending on whether the touch operation is performed only once, or two or more times within the prescribed time period. Therefore, it is possible to facilitate the operation for changing the dimming level. In addition, since the brightness can be directly switched from the non-lighting state to the lighting state at the first dimming level, or to the lighting state at the second dimming level, it is possible to reduce a time required until the illumination load is turned on at the first or second dimming level.

### BRIEF DESCRIPTION OF THE DRAWINGS

Preferred embodiments of the present invention will now be described in further details. Other features and advantages of the present invention will become better understood with regard to the following detailed description and accompanying drawings where:
Fig. 1 is a block diagram illustrating a wall switch of an embodiment;
Fig. 2 is a front view of the wall switch, in a construction state, of the embodiment; and
Fig. 3 is a state transition diagram for explaining operation of the wall switch of the embodiment.

### BEST MODE FOR CARRYING OUT THE INVENTION

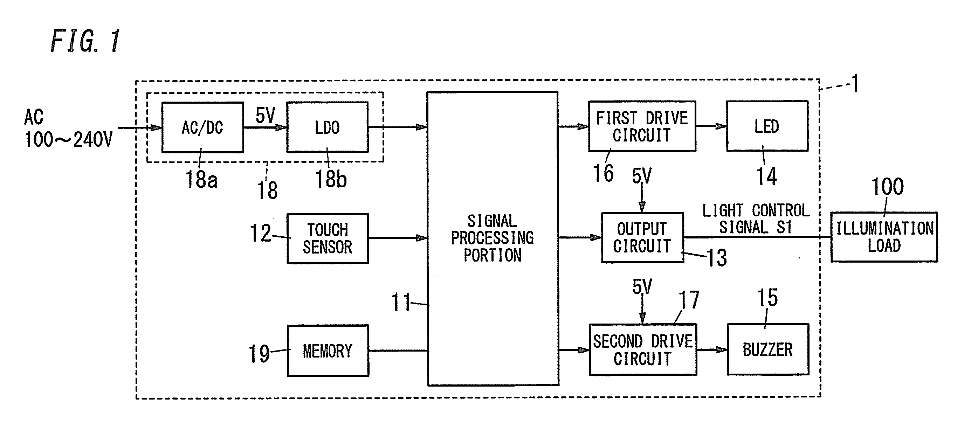

A wall switch of the present embodiment according to the present invention will be described with reference to Figs. 1 to 3.

A wall switch **1** of the present embodiment is used for controlling operation of an illumination load **100,** of which lighting can be controlled. The illumination load **100** is an LED luminaire that is configured to change a dimming level of a light emitting diode (not shown) as a light source, according to a voltage level of a light control signal S1 received from the wall switch 1.

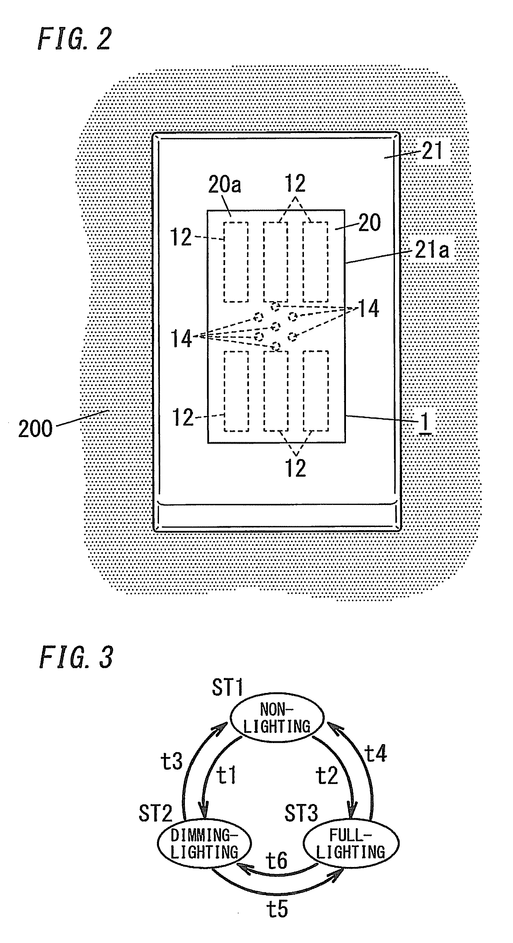

Fig. 2 is a front view of the wall switch 1 in a state of being mounted on a wall **200.** Hereinafter, unless otherwise specified, a vertical direction and a horizontal direction are defined and described based on Fig. 2.

A switch body 20 of the wall switch 1 is formed of synthetic resin into a box-shape. When viewed from the front, the switch body **20** has a rectangle which is vertically long (that is, a length in the vertical direction is larger than that in the horizontal direction). The switch body **20** is mounted on the wall **200** with a mounting frame (not shown) which is used for mounting a flush type wiring appliance on the wall **200.** A decorative frame **21** is mounted on the front side of the mounting frame. A front surface of the switch body **20** is exposed from an opening **21a** provided in the center of the decorative frame **21.** Note that, because the mounting frame has a conventionally well-known structure as disclosed in JP 2009-74936 A for example, drawings and explanations thereof are omitted.

Fig. 1 is a block diagram illustrating the wall switch **1.** The wall switch **1** includes a signal processing portion **11,** touch sensors **12** (Fig. 1 shows only one touch sensor), an output circuit **13,** light emitting diodes (LEDs) **14** (Fig. 1 shows only one LED), a buzzer **15,** a first drive circuit **16,** a second drive circuit **17,** a power supply circuit **18** and a memory **19.** Note that, a circuit substrate (not shown), on which circuit components constituting circuits in Fig. 1 are mounted, is housed in the switch body 20.

The signal processing portion **11** is configured by, for example, a microcomputer to perform the overall control of the wall switch **1.** The signal processing portion **11** is configured to control a lighting state of the illumination load **100** based on detection results of the touch sensors **12.** Note that, control contents according to a touch operation will be described later.

Each touch sensor **12** is a capacitance type sensor, and an output of each touch sensor **12** is output to the signal processing portion **11.**

The touch sensors **12** are disposed on a back side of a front wall of the switch body **20.** The number of touch sensors **12** may be one or more. The touch sensors **12,** which are required for covering an operation area 20a provided on the substantially entire of the front wall of the switch body 20, are disposed on the back side of the front wall of the switch body **20.** Since the switch body **20** is formed of synthetic resin, when the operation area **20a** of the switch body **20** is touched with a finger for a touch operation, a capacitance value of a touch sensor(s) **12** is changed, which is disposed near the back side of a part touched with the finger, and accordingly, an output of the touch sensor(s) **12** is also changed. Note that, the touch sensors **12** are not limited to capacitance type sensors, and a well-known detecting type, such as a resistance film type, may be used.

Here, an operation of tapping the operation area **20a** once with the finger within a prescribed time period is referred to as a "tap operation", and an operation of tapping the operation area 20a two or more times with the finger within the prescribed time period is referred to as a "continuous tap operation". In particular, regarding the continuous tap operation, an operation of tapping the operation area **20a** two times with the finger within the prescribed time period is referred to as a "double tap operation". Note that, the above-mentioned prescribed time period is a time period of a degree capable of determining that the touch operation has been continuously performed two or more times, and is set as a time period of about 0.5 sec to 1.0 sec for example.

More specifically, the signal processing portion **11** includes a timer (not shown) for clocking the prescribed time period. The timer starts clocking of the prescribed time period when the touch sensors **12** detect the touch operation. The signal processing portion **11** is configured to not change the brightness of the illumination load **100** before clocking of the prescribed time period by the timer is completed. The signal processing portion **11** is further configured to change the brightness of the illumination load **100** according to the number of times of the touch operation within the prescribed time period.

The output circuit **13** is configured to change a voltage level of an output signal **S1** according to a control instruction received from the signal processing portion **11.** The output signal **S1** of the output circuit **13** is output to the illumination load **100.** The illumination load **100** controls the dimming level of the light emitting diode (not shown) as the light source, according to the voltage level of the output signal **S1.**

Each of light emitting diodes **14** (e.g., seven diodes) is an RGB full-color light emitting diode for example. Regarding the light emitting diodes **14,** one light emitting diode **14** is disposed at a position corresponding to a central position of the operation area **20a** on the back side of the front wall of the switch body 20, and the remaining six light emitting diodes **14** are arranged at equal intervals on a circumference around the one light emitting diode **14** as the center. The front wall of the switch body **20** is formed so as to have a thickness of a degree capable of transmitting light emitted from the light emitting diodes **14.**

The first drive circuit **16** is configured to individually control turning on/off of the light emitting diodes **14** and further emission colors of the light emitting diodes **14** when turning on the light emitting diodes **14,** according to an input signal received from the signal processing portion **11.**

The second drive circuit **17** is configured to sound the buzzer **15,** according to the input signal received from the signal processing portion **11.**

The power supply circuit **18** includes an AC/DC converter (AC/DC) **18a,** and an LDO (Low Drop Out) regulator (LDO) 18b. The AC/DC converter **18a** is configured to convert AC power supplied from a commercial AC power source into DC power. The LDO regulator **18b** is configured to reduce an output voltage of the AC/DC converter **18a** to a prescribed voltage, and supply the prescribed voltage to the signal processing portion 11. Note that, the configuration of the power supply circuit **18** is not limited to the present embodiment, and may be changed appropriately.

The memory **19** is an electrically rewritable nonvolatile memory, such as an EEPROM, and previously stores setting values of a first dimming level at which the illumination load **100** is turned on through the tap operation, and a second dimming level at which the illumination load **100** is turned on through the continuous tap operation. In the present embodiment, for example, a dimming level of 70% is set as the first dimming level, and a dimming level of 100% is set as the second dimming level. The values of the first and second dimming levels may be previously set at a factory, or may be changed by a user through a suitable means such as a volume controller or a switch.

Next, operation of the wall switch **1** will be described. The signal processing portion **11** is configured to perform load control based on detection results of the touch sensors **12,** and Fig. 3 shows a state transition diagram representing the operation.

When the illumination load **100** is in a non-lighting state (a state **ST1**), the signal processing portion **11** controls the first drive circuit **16** to turn on the light emitting diodes **14** in green, and accordingly, positions of the wall switch **1** and the operation area **20a** are visually provided.

When the illumination load **100** is in the non-lighting state, if an operator taps the operation area **20a** only once with the operator's finger within the prescribed time period (the tap operation) (an event t1), the touch sensors **12** detect the touch operation only once within the prescribed time period. In this case, because the touch sensors **12** detect no next touch operation during the lapse of the prescribed time period after detecting the touch operation, the signal processing portion **11** reads out the setting value of the first dimming level from the memory **19.** The signal processing portion **11** then allows the output circuit **13** to output the light control signal **S1** according to the read out dimming level to the illumination load **100,** and accordingly, the illumination load **100** is turned on at the first dimming level (a state **ST2**). In the present embodiment, since the first dimming level is set to 70%, the illumination load **100** is turned on at the dimming level of 70% in the state **ST2.** The signal processing portion **11** further controls the second drive circuit **17** to output a notification sound (e.g., a beep "Pi") through the buzzer **15,** and accordingly, the operator is informed that the touch operation has been accepted. The signal processing portion **11** further controls the first drive circuit **16** to turn on the light emitting diodes **14** in red, and accordingly, the information that the illumination load **100** is in the lighting state is visually provided.

When the illumination load **100** is in the non-lighting state, if the operator taps the operation area **20a** two or more times with the operator's finger within the prescribed time period (the continuous tap operation) (an event **t2**), the touch sensors **12** detect the touch operation two or more times within the prescribed time period. In this case, because the touch sensors **12** detect the next touch operation during the lapse of the prescribed time period after detecting the touch operation, the signal processing portion **11** reads out the setting value of the second dimming level from the memory **19.** The signal processing portion **11** then allows the output circuit **13** to output the light control signal **S1** according to the read out dimming level to the illumination load **100,** and accordingly, the illumination load **100** is turned on at the second dimming level (a state **ST3**). In the present embodiment, since the second dimming level is set to 100%, the illumination load **100** is turned on so as to be in a full-lighting state in the state ST3. The signal processing portion **11** further controls the second drive circuit **17** to output a notification sound (e.g., a beep "Pi, Pi") through the buzzer **15,** and accordingly, the operator is informed that the continuous touch operation has been accepted. The signal processing portion **11** further controls the first drive circuit **16** to turn on the light emitting diodes **14** in red, and accordingly, the information that the illumination load **100** is in the lighting state is visually provided.

When the illumination load **100** is in the lighting state at the first dimming level or the second dimming level (states **ST2, ST3**), if the operator taps the operation area **20a** only once with the operator's finger within the prescribed time period (events **t3, t4**), the touch sensors **12** detect the touch operation only once within the prescribed time period. When the illumination load **100** is in the lighting state, if the touch sensors **12** detect no next touch operation during the lapse of the prescribed time period after detecting the touch operation, the signal processing portion **11** allows the output circuit **13** to stop outputting of the light control signal **S1,** and accordingly, the illumination load **100** is turned off (the state **ST1**). The signal processing portion **11** further controls the second drive circuit **17** to output the notification sound (e.g., a beep "Pi") through the buzzer **15,** and accordingly, the operator is informed that the touch operation has been accepted. The signal processing portion **11** further controls the first drive circuit **16** to turn on the light emitting diodes **14** in green, and accordingly, the positions of the wall switch and the operation area are visually provided.

When the illumination load **100** is in the lighting state at the first dimming level (the state **ST2**), if the operator taps the operation area 20a two or more times with the operator's finger within the prescribed time period (an event **t5**), the touch sensors **12** detect the touch operation two or more times within the prescribed time period. In this case, because the touch sensors **12** detect the next touch operation during the lapse of the prescribed time period after detecting the touch operation, the signal processing portion **11** reads out the setting value of the second dimming level from the memory **19** to switch the dimming level. The signal processing portion **11** then allows the output circuit **13** to output the light control signal **S1** according to the read out dimming level to the illumination load **100,** and accordingly, the illumination load **100** is turned on at the second dimming level (the state **ST3**). In the present embodiment, since the second dimming level is set to 100%, the illumination load **100** is turned on so as to be in the full-lighting state in the state **ST3.** The signal processing portion **11** further controls the second drive circuit **17** to output the notification sound (e.g., a beep "Pi, Pi") through the buzzer **15,** and accordingly, the operator is informed that the continuous touch operation has been accepted.

When the illumination load **100** is in the lighting state at the second dimming level (the state **ST3**), if the operator taps the operation area **20a** two or more times with the operator's finger within the prescribed time period (an event **t6**), the touch sensors **12** detect the touch operation two or more times within the prescribed time period. In this case, because the touch sensors **12** detect the next touch operation during the lapse of the prescribed time period after detecting the touch operation, the signal processing portion **11** reads out the setting value of the first dimming level from the memory **19** to switch the dimming level. The signal processing portion **11** then allows the output circuit **13** to output the light control signal **S1** according to the read out dimming level to the illumination load **100,** and accordingly, the illumination load **100** is turned on at the first dimming level (the state **ST2**). In the present embodiment, since the first dimming level is set to 70%, the illumination load **100** is turned on at the dimming level of 70% in the state **ST2.** The signal processing portion **11** further controls the second drive circuit 17 to output the notification sound (e.g., a beep "Pi, Pi") through the buzzer **15,** and accordingly, the operator is informed that the continuous touch operation has been accepted.

Summarizing the above-mentioned operation, in the non-lighting state, if the touch operation is performed only once within the prescribed time period, the wall switch **1** turns on the illumination load **100** at the first dimming level, and if the touch operation is performed two or more times within the prescribed time period, the wall switch **1** turns on the illumination load **100** at the second dimming level. When the illumination load **100** is in the lighting state at the first or second dimming level, if the touch operation is performed only once within the prescribed time period, the wall switch **1** turns off the illumination load **100.** When the illumination load **100** is in the lighting state at the first or second dimming level, if the touch operation is performed two or more times within the prescribed time period, the wall switch 1 switches the dimming level of the illumination load **100** from the first dimming level to the second dimming level, or from the second dimming level to the first dimming level.

As described above, the wall switch **1** of the present embodiment includes a touch sensor **12** and a lighting controller. The touch sensor **12** is configured to detect the touch operation of touching the prescribed operation area **20a** with the finger. The lighting controller includes the signal processing portion **11** and the output circuit **13,** and is configured to control lighting of the illumination load **100** based on the detection result of the touch sensor **12.** When the illumination load **100** is in the non-lighting state, the lighting controller is configured to turn on the illumination load **100** at the first dimming level, if the touch sensor **12** detects no next touch operation during the lapse of the prescribed time period after detecting the touch operation. When the illumination load **100** is in the non-lighting state, the lighting controller is configured to turn on the illumination load **100** at the second dimming level that is different from the first dimming level, if the touch sensor **12** detects the next touch operation during the lapse of the prescribed time period after detecting the touch operation.

Accordingly, in the non-lighting state of the illumination load **100,** if the touch operation is performed only once within the prescribed time period, the lighting controller including the signal processing portion **11** and the output circuit **13** turns on the illumination load **100** at the first dimming level based on the detection result of the touch sensor **12.** In the non-lighting state of the illumination load **100,** if the touch operation is performed two or more times within the prescribed time period, the lighting controller turns on the illumination load **100** at the second dimming level based on the detection result of the touch sensor **12.** In this way, the brightness of the illumination load **100** can be directly switched to the first dimming level or the second dimming level, depending on whether the touch operation is performed only once, or two or more times within the prescribed time period. Therefore, it is possible to facilitate the operation for changing the dimming level. In addition, since the brightness can be directly switched from the non-lighting state to the lighting state at the first dimming level, or to the lighting state at the second dimming level, it is possible to reduce a time required until the illumination load is turned on at the first or second dimming level.

In the present embodiment, preferably, when the illumination load **100** is in the lighting state at the first dimming level, the lighting controller is configured to turn off the illumination load **100,** if the touch sensor **12** detects no next touch operation during the lapse of the prescribed time period after detecting the touch operation. Further, preferably, when the illumination load **100** is in the lighting state at the first dimming level, the lighting controller is configured to turn on the illumination load **100** at the second dimming level, if the touch sensor **12** detects the next touch operation during the lapse of the prescribed time period after detecting the touch operation.

In the present embodiment, preferably, when the illumination load **100** is in the lighting state at the second dimming level, the lighting controller is configured to turn off the illumination load **100,** if the touch sensor **12** detects no next touch operation during the lapse of the prescribed time period after detecting the touch operation. Further, preferably, when the illumination load **100** is in the lighting state at the second dimming level, the lighting controller is configured to turn on the illumination load **100** at the first dimming level, if the touch sensor **12** detects the next touch operation during the lapse of the prescribed time period after detecting the touch operation.

In the present embodiment, the second dimming level is preferably the dimming level of 100%.

Note that, as a matter of course, when the illumination load **100** is in the lighting state at the first or second dimming level, a change destination of the brightness, corresponding to the number of times of the touch operation within the prescribed time period, is not limited to the above-mentioned contents. The change destination may be as follows.

That is, when the illumination load **100** is in the lighting state at the first dimming level, the lighting controller may be configured to turn on the illumination load **100** at the second dimming level, if the touch sensor **12** detects no next touch operation during the lapse of the prescribed time period after detecting the touch operation. Further, when the illumination load **100** is in the lighting state at the first dimming level, the lighting controller may be configured to turn off the illumination load **100,** if the touch sensor **12** detects the next touch operation during the lapse of the prescribed time period after detecting the touch operation. When the illumination load **100** is in the lighting state at the second dimming level, the lighting controller may be configured to turn on the illumination load **100** at the first dimming level, if the touch sensor **12** detects no next touch operation during the lapse of the prescribed time period after detecting the touch operation. Further, when the illumination load **100** is in the lighting state at the second dimming level, the lighting controller may be configured to turn off the illumination load **100,** if the touch sensor **12** detects the next touch operation during the lapse of the prescribed time period after detecting the touch operation.

Although the present invention has been described with reference to certain preferred embodiments, numerous modifications and variations can be made by those skilled in the art without departing from the true spirit and scope of this invention, namely claims.

## Claims

1. A wall switch, comprising:
a touch sensor configured to detect a touch operation of touching a prescribed operation area with a finger; and
a lighting controller configured to control lighting of an illumination load based on a detection result of the touch sensor,
wherein, when the illumination load is in a non-lighting state, the lighting controller is configured to turn on the illumination load at a first dimming level, if the touch sensor detects no next touch operation during a lapse of a prescribed time period after detecting the touch operation, and
wherein, when the illumination load is in the non-lighting state, the lighting controller is configured to turn on the illumination load at a second dimming level that is different from the first dimming level, if the touch sensor detects a next touch operation during the lapse of the prescribed time period after detecting the touch operation.

2. The wall switch according to claim 1,
wherein, when the illumination load is in a lighting state at the first dimming level, the lighting controller is configured to turn off the illumination load, if the touch sensor detects no next touch operation during the lapse of the prescribed time period after detecting the touch operation, and
wherein, when the illumination load is in the lighting state at the first dimming level, the lighting controller is configured to turn on the illumination load at the second dimming level, if the touch sensor detects the next touch operation during the lapse of the prescribed time period after detecting the touch operation.

3. The wall switch according to claim 1 or 2,
wherein, when the illumination load is in a lighting state at the second dimming level, the lighting controller is configured to turn off the illumination load, if the touch sensor detects no next touch operation during the lapse of the prescribed time period after detecting the touch operation, and
wherein, when the illumination load is in the lighting state at the second dimming level, the lighting controller is configured to turn on the illumination load at the first dimming level, if the touch sensor detects the next touch operation during the lapse of the prescribed time period after detecting the touch operation.

4. The wall switch according to claim 1, wherein the second dimming level is a dimming level of 100%.
